Europäisches Patentamt

European Patent Office

Office européen des brevets

(11) Veröffentlichungsnummer: **0 232 946**
**A2**

## (12) EUROPÄISCHE PATENTANMELDUNG

(21) Anmeldenummer: **87200188.8**

(22) Anmeldetag: **09.02.87**

(51) Int. Cl.4: **G01N 24/08**

(30) Priorität: **12.02.86 DE 3604280**

(43) Veröffentlichungstag der Anmeldung:
**19.08.87 Patentblatt 87/34**

(84) Benannte Vertragsstaaten:
**DE FR GB NL SE**

(71) Anmelder: **Philips Patentverwaltung GmbH**
**Billstrasse 80**
**D-2000 Hamburg 28(DE)**
**DE**
Anmelder: **N.V. Philips' Gloeilampenfabrieken**
**Groenewoudseweg 1**
**NL-5621 BA Eindhoven(NL)**
**FR GB NL SE**

(72) Erfinder: **Twieg, Donald B.**
**9636 Arborhill**
**Dallas Texas 75243(US)**

(74) Vertreter: **Hartmann, Heinrich, Dipl.-Ing. et al**
**Philips Patentverwaltung GmbH Billstrasse**
**80 Postfach 10 51 49**
**D-2000 Hamburg 28(DE)**

(54) **Verfahren zur Bestimmung der räumlichen und der spektralen Verteilung der Kernmagnetisierung in einem Untersuchungsbereich und Anordnung zur Durchführung des Verfahrens.**

㊼ Die Erfindung betrifft ein Verfahren zur Bestimmung der räumlichen und der spektralen Verteilung der Kernmagnetisierung in einem Untersuchungsbereich. Dabei wird im Anschluß an einen Hochfrequenzanregungsimpuls ein periodisch seine Polarität änderndes magnetisches Gradientenfeld eingeschaltet. Das Auflösungsvermögen wird dabei dadurch erhöht, daß auch während der Zeiträume, während der sich der Gradient dieses Feldes ändert, Abtastwerte erfaßt und einer Fourier-Transformation unterzogen werden.

Fig.4

**"Verfahren zur Bestimmung der räumlichen und der spektralen Verteilung der Kernmagnetisierung in einem Untersuchungsbereich und Anordnung zur Durchführung des Verfahrens"**

Die Erfindung betrifft ein Verfahren zur Bestimmung der räumlichen und der spektralen Verteilung der Kernmagnetisierung in einem Untersuchungsbereich, bei dem in Anwesenheit enes homogenen stationären Magnetfeldes eine Anzahl von Sequenzen auf den Untersuchungsbereich einwirkt, wobei jede Sequenz mindestens einen magnetischen Hochfrequenzimpuls zur Anregung kernmagnetischer Resonanz und daran anschließend mehrere Perioden eines magnetischen Gradientenfeldes mit periodisch seine Polarität änderndem Gradienten umfaßt, wonach die dabei im Untersuchungsbereich erzeugten Echosignale in digitale Abtastwerte umgesetzt und diese ener diskreten Fourier-Transformation unterzogen werden. Ein solches Verfahren ist bekannt (Matsui et al, J.Am.Chem.Soc. 1985, 107, Seiten 2817 bis 2818). Außerdem betrifft die Erfindung eine Anordnung zur Durchführung des Verfahrens.

Jede Sequenz umfaßt dabei zwei Hochfrequenzimpulse, die den Magnetisierungsvektor im Untersuchungsbereich um 90° bzw. um 180° aus seiner vorherigen Lage kippen. Zwischen den beiden Impulsen bzw. unmittelbar danach wird zum Zwecke der Phasenkodierung ein Gradientenfeld eingeschaltet, dessen Gradient von Sequenz zu Sequenz geändert. Nachdem dieses Gradientenfeld wieder abgeschaltet ist, wrd ein weiteres magnetisches Gradientenfeld, dessen Gradient n einer zur (y-)Richtung des Gradienten des zuvor genannten Gradientenfeldes senkrechten Richtung (d.h. in x-Richtung) verläuft und sich periodisch von einen positiven auf einen negativen Wert ändert. Nach jedem Umschalten des Gradienten wird ein Echosignal erzeugt. Die Echosignale, die bei positiven - (oder bei negativen) Gradienten entstehen, werden indigitale Abtastwerte umgesetzt und einer Fourier-Transformation unterzogen. Die dabei erzeugten digitalen Abtastwerte lassen sich jeweils in drei verschiedenen Gruppen einordnen:
Die erste Gruppe umfaßt die äquidistanten Abtastwerte eines Echosignals. Die zweite Gruppe umfaßt Abtastwerte, die in verschiedenen Sequenzen jeweils bei dem gleichen Echosignal und in der gleichen Phase in bezug auf das periodische Gradientenfeld auftreten, und die dritte Gruppe umfaßt die Abtastwerte, die in verschiedenen Echosgnalen der gleichen Sequenz jeweils in der gleichen Phase bezüglich des Gradientenfeldes auftreten. Der zeitliche Abstand der Abtastwerte einer Gruppe ist jeweils gleich; er ist in der ersten Gruppe am kleinsten und in der zweiten Gruppe am größten.

Die so erhaltenen Gruppen von Abtastwerten werden einer dreidimensionalen diskreten Fourier-Transformation unterzogen, woraus sich die Kernmagnetisierung im Untersuchungsbereich als Funktion des Ortes (x, y) und als Funktion der Frequenz (genauer: als Funktion der Frequenzabweichung von der Mittenfrequenz des Hochfrequenzanregungsimpulses) ergibt.

Die Bandbreite, innerhalb der die Kernmagnetisierung erfaßt werden kann, entspricht dabei der Frequenz des magnetschen Gradientenfeldes. Hat dieses beispielsweise eine Periodendauer von 4,992 ms, dann ergibt sich eine Bandbreite von 200,3 Hz. Dieser Frequenzbereich kann in einer Anzahl von Unterbereichen aufgelöst werden, deren Zahl der Zahl der Perioden des periodischen Gradientenfeldes innerhalb einer Sequenz entspricht.

Bei dem bekannten Verfahren verläuft das periodische Gradientenfeld zeitlich praktisch rechteckförmig, so daß die Abtastwerte immer in Zeitpunkten erfaßt werden, in denen der Gradient konstant und etweder positiv oder negativ ist (in Wirklichkeit ist der zeitliche Verlauf nicht exakt rechteckförmig, doch ist die Umschaltzeit (50 μs) kürzer als der zeitliche Abstand zwischen zwei Abtastwerten (78 μs), so daß das Echosignal immer in Zeitpunkten abgetastet wird, in denen der Gradient konstant und etweder positiv oder negativ ist.

Das räumliche Auflösungsvermögen, in der Richtung, in der der Gradient des periodischen magnetischen Gradientenfeldes verläuft, ist begrenzt; die höchste Ortsfrequenz in dieser Richtung ist dem zeitlichen Integral über den positiven bzw. den negativen Teil der Periode des Gradienten proportional. Eine Erhöhung dieses Wertes durch Vergrößern des Gradienten ist nicht möglich, wenn der Strom durch die Gradientenspulen, mit Hilfe dessen das Gradientenfeld erzeugt wird, bereits seinen Höchstwert erreicht hat. Auch die Vergrößerung des Auflösungsvermögens durch Vergrößerung der Periodendauer des periodischen Gradientenfeldes ist praktisch nicht möglich, weil dadurch die auflösbare Bandbreite, die dem Kehrwert der Periodendauer entspricht, abnimmt.

Bei Kernspin-Untersuchungsgeräten zur Untersuchung des menschlichen Körpers ist das räumliche Auflösungsvermögen in der Praxis noch weiter eingeschränkt. Die Gradientenspulen müssen dabei nämlich so groß sein, daß ein Patient darin Platz hat. Infolgedessen besitzen sie eine größere Induktivität und speichern mehr elektromagnetische Energie als kleinere Spulen. Infolgedessen dauert die Umschaltphase von einem positiven zu einem negativen Gradienten (und umgekehrt) wesentlich länger als bei dem bekannten Verfahren, so daß die Dauer der Umschaltphase ein Vielfaches des zeitlichen Abstandes zwischen zwei aufeinanderfolgenden Abtastungen eines im Untersuchungsbereich erzeugten Echosignals betragen kann. Die Abtastung der Echosignale muß dabei auf die Zeitintervalle beschränkt werden, in denen der Gradient konstant ist. Das zeitliche Integral über den Gradienten während dieses Intervalls ist aber (bei gleicher Stärke des Gradienten und bei gleicher Periodendauer) noch kleiner als bei einem rechteckförmigen Verlauf des magnetischen Gradientenfeldes, woraus ein verringertes Auflösungsvermögen resultiert.

Aufgabe der vorliegenden Erfindung ist es, ein Verfahren anzugeben, das demgegenüber bei einem zeitlich von der Rechteckform abweichenden Verlauf des periodischen Gradientenfeldes ein verbessertes Auflösungsvermögen ergibt sowie eine Anordnung zur Durchführung dieses Verfahrens.

Ausgehend von einem Verfahren der eingangs genannten Art wird diese Aufgabe erfindungsgemäß dadurch gelöst, daß der zeitliche Verlauf des magnetischen Gradientenfeldes von der Rechteckform abweicht, daß auch die Abtastwerte erfaßt werden, die auftreten, wenn das Gradientenfeld sich ändert und daß diese und die übrigen Abtastwerte dem Raumfrequenzbereich zugeordnet und aus diesem durch die Fourier-Transformation in den Raumbereich transformiert werden.

Bei dem erfindungsgemäßen Verfahren werden die Echosignale also auch in den Phasen abgetastet, in denen der Gradient des periodischen Gradientenfeldes sich ändert, insb. also auch in den Umschaltphasen.

Wenn die Echosignale dabei -wie allgemein üblich -in äquidistanten Zeitpunkten n digitale Abtastwerte umgesetzt werden, würde eine unmittelbare Fourier-Transformation mittels dieser Abtastwerte zu Fehlern führen. Um dies zu vermeiden, werden bei der Erfindung die Abtastwerte jeweils den Raumfrequenzen zugeordnet, bei denen sie erfaßt wurden. Die Abtastwerte haben wegen des veränderten Gradienten im Raumfrequenzbereich nicht den gleichen Abstand voneinander. Die darauf folgende Fourier-Transformation muß also so ausgelegt sein, daß sie anhand von an nicht äquidistanten Stützstellen diskret vorgegebenen Funktionswerten ausgeführt werden kann. Derartige Fourier-Transformationsverfahren snd jedoch bekannt, z.B. aus "ntz Archiv" Bd. 3 (1981) Heft 2, Seiten 35 bis 38.

Die Zuordnung zum Raumfrequenzbereich kann auch dadurch erfolgen, daß das Signal von vornherein zeitlich nicht äquidistant abgetastet wird derart, daß die dabei erfaßten Abtastwerte im Raumfrequenzbereich jeweils den gleichen Abstand voneinander haben.

Eine Anordnung zur Durchführung dieses Verfahrens mit einem Magneten zur Erzeugung eines homogenen stationären Magnetfeldes, ener Hochfrequenzspule zur Erzeugung von Hochfrequenzanregungsimpulsen, Gradientenspulen zur Erzeugung von magnetischen Gradientenfeldern mit in unterschiedlichen Richtungen verlaufenden Gradienten, einer Steuereinrichtung zur Steuerung des zeitlichen Verlaufs der mit den Gradientenspulen erzeugten Felder, einer Digital-Wandler-Aordnung zur Erzeugug digitaler Abtastwerte aus den Echosignalen, einem Speicher zur Aufnahme der Abtastwerte und einem Rechner zur Durchführung einer Fourier-Transformation mit den Abtastwerten, ist dadurch gekennzeichnet, daß die Steuereinrichtung so ausgelegt ist, daß wenigstens eine der Gradientenspulen ein periodisches Magnetfeld mit einem von der Rechteckform abweichenden zeitlichen Verlauf erzeugt, daß während der Zeiträume mit nicht konstantem Gradienten von der Digital-Wandler-Anordnung aus den Echosignalen digitale Abtastwerte erzeugt und in dem Speicher gespeichert werden, und daß Mittel vorgesehen sind, die die Folge der Abtastwerte in eine in Raumfrequenzbereich äquidistante Folge von Werten umsetzen, die dem Rechner zur Fourier-Transformation vom Raumfrequenzbereich in den Raumbereich zugeführt werden.

Wie aus der eingangs zitierten Literaturstelle bekannt ist, läßt sich nur jedes zweite Echosignal auswerten. Die verbliebenen Echosignale können zwar ebenfalls zu einer Gruppe zusammengefaßt und einer Fourier-Transformation unterzogen werden, jedoch läßt sich auf diese Wese allenfalls der Einfluß des Rauschens reduzieren. Es läßt sich jedoch eine Halbierung der Meßzeit dadurch erreichen, daß auch ein zweites magnetisches Gradientenfeld, dessen Gradienten senkrecht zum Gradienten des ersten Gradientenfeldes verläuft, synchron mit dem ersten Gradientenfeld umgeschaltet wird, wobei die Änderung des zeitlichen Integrals über den Gradienten des zweiten Gradientenfeldes klein ist im Vergleich zu dem zeitlichen Integral über den resultierenden Gradienten beider Gradientenfelder, und daß die bei positivem Gradienten des ersten magnetischen Gradientenfeldes einerseits und bei negativem Gradienten andererseits auftretenden Echosignale in digitale Abtastwerte umgesetzt und getrennt einer Fourier-Transformation unterzogen werden. Hierbei werden be positiver Polarität des Gradienten des magnetischen Gradientenfeldes andere Gebiete des Raumfrequenz-Zeit-Bereiches als bei negativer Polarität erfaßt, so daß die Zeit für die Erfassung der diesem Bereich zugeordneten Abtastwerte halbiert wird.

Die Erfindung wird nachstehend anhand der Zechnungen näher erläutert. Es zeigen:

Fig. 1 ein Kernspin-Untersuchungsgerät, bei dem Erfindung anwendbar ist,

Fig. 2 ein Blockschaltbild eines solchen Gerätes,

Fig. 3 den zeitlichen Verlauf verschiedener Signale bei einer erfindungsgemäßen Sequenz,

Fig. 4 die Zuordnung der Abtastwerte zum Raumfrequenzbereich,

Fig. 5 und 6 die Erfassung der Abtastwerte im Raumfrequenz-Zeitbereich bei einer bevorzugten Ausführungsform des Verfahrens,

Fig. 7 die Erfassung der Abtastwerte im Raumfrequenz-Zeitbereich bei einer anderen Variante und

Fig. 8 den zeitlichen Verlauf des periodischen Gradientenfeldes bei einer Ausführungsform, die eine vergrößerte Bandbreite ergibt.

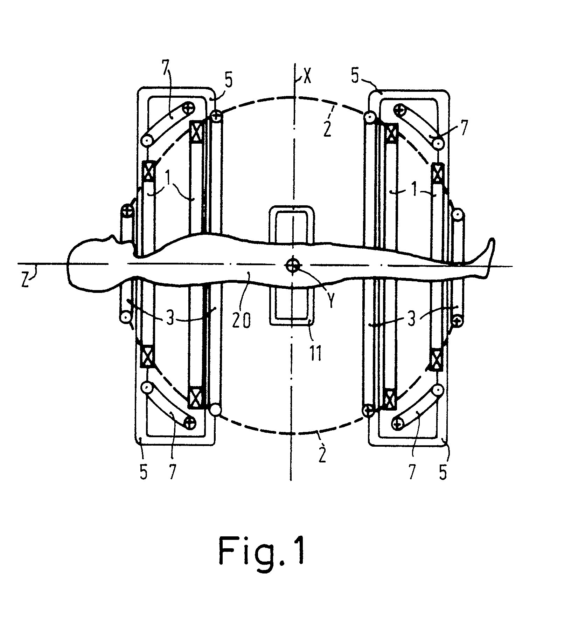

Das in Fig. 1 schematisch dargestellte Kernspin-Tomographiegerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Rchtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes Magnetfeld Gx erzeugen, dessen Gradient jedoch in x-Richtung verläuft.

En in z-Richtung verlaufendes Magnetfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen 5 sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Zentrum der Kugel, das gleichzeitig den Koordinatenursprung des kartesischen x, y, z-Koordinatensystems bildet, nur durch das stationäre homogene Magnetfeld der Spulenanordnung 1 bestimmt. Weiterhin ist eine Hochfrequenzspule 1 symmetrisch zur Ebene z = 0 des Koordinatensystems angeordnet, die so ausgebildet ist, daß damit ein im wesentlichen homogenes in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. -Im Anschluß an einen oder mehrere Hochfrequenzimpulse dient die Hochfrequenzspule 11 zum Empfangen der durch Kernspinresonanz im Untersuchungsbereich erzeugten Echosignale. Stattdessen kann aber auch eine gesonderte Hochfrequenz-Empfangsspule verwendet werden.

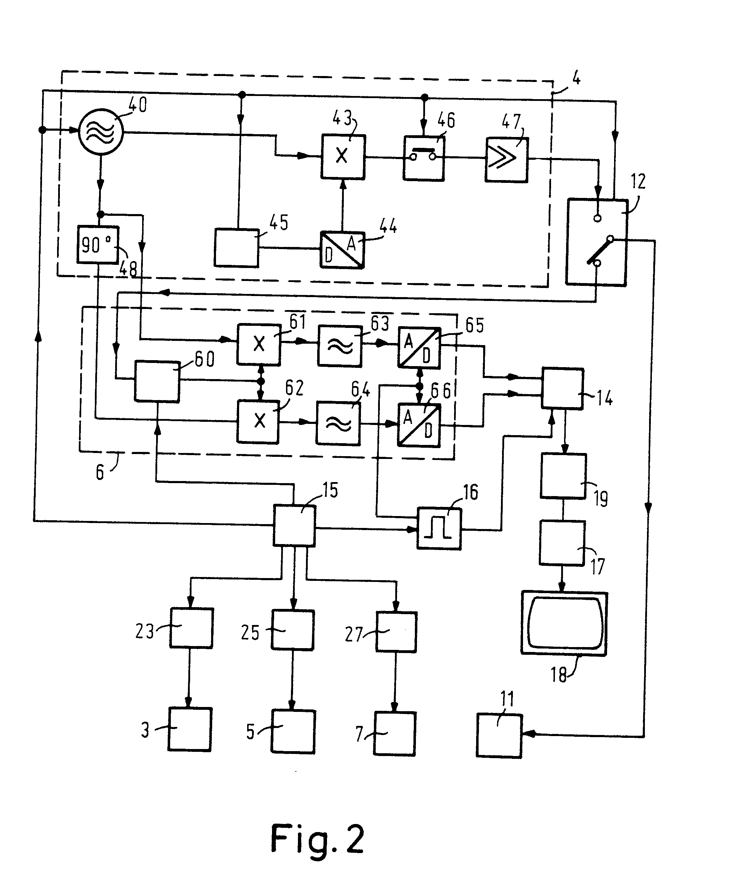

Fig. 2 zeigt ein vereinfachtes Blockschaltbild dieses Kernspin-Tomographen. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen Hochfrequenzoszillator 40, der Schwingungen mit einer Frequenz gleich der Larmorfrequenz der Wasserstoffprotonen bei der von den Spulen 1 erzeugten Feldstärke aufweist; bei einer Feldstärke von 0,5 T beträgt diese Frequenz rund 21,3 MHz und bei 2 T rund 85 MHz. Der Ausgang des Oszilators 40 ist mit einem Eingang einer Mischstufe 43 verbunden. Der Mischstufe 43 wird ein zweites Eingangssignal von einem Digital-Analog-Wandler 44 zugeführt, dessen Eingang mit einem digitalen Speicher 45 verbunden ist. Aus dem Speicher 45 wird -gesteuert durch eine Steuereinrichtung 15 -eine Folge von ein Hüllkurvensignal darstellenden digitalen Datenworten ausgelesen.

Die Mischstufe 17 verarbeitet die ihr zugeführten Eingangssignale so, daß an ihrem Ausgang die mit dem Hüllkurvensignal modulierte Trägerschwingung erscheint. Das Hüllkurvensignal ist dabei so gewählt, daß sich ein vorzugsweise amplitudenmoduliertes Signal ergibt, dessen Bandbreite relativ groß ist. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung 12 verbunden ist und dem die in der Hochfrequenzspule 11 induzierten durch Kernspinresonanz hervorgerufenen Echosignale zugeführt werden, wenn die Umschalteinrichtung 12 entsprechend gesteuert ist. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers 60 ist mit den ersten Eingängen zweier multiplikativer Mischstufen 61 und 62 verbunden, die jeweils ein dem Produkt ihrer Eingangssignale entsprechendes Ausgangssignal liefern. Dem zweiten Eingang der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufen 61 und 62 werden über Tiefpässe 63 und 64, die die vom Oszillator 40 gelieferte Frequenz sowie alle darüber liegenden Frequenzen unterdrücken und nur niederfrequente Anteile durchlassen, je einem Analog-Digital-Wandler 65 bzw. 66 zugeführt. Dieser setzt die analogen Signale der einen Quadraturdemodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten in den Niederfrequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinhet 15 steuerbar ist. -Die im Speicher 14 gespeicherten digitalen Abtastwerte werden über eine Zuordnungseinrichtung 19, deren Funktion noch erläutert wird, einem Rechner 17 zugeführt, der anhand der Abtastwerte die räumliche Verteilung der Kernmagnetisierung im Untersuchungsbereich ermittelt und die ermittelte Verteilung an einer geeigneten Wiedergabeeinheit, z.B. einen Monitor 18, ausgibt.

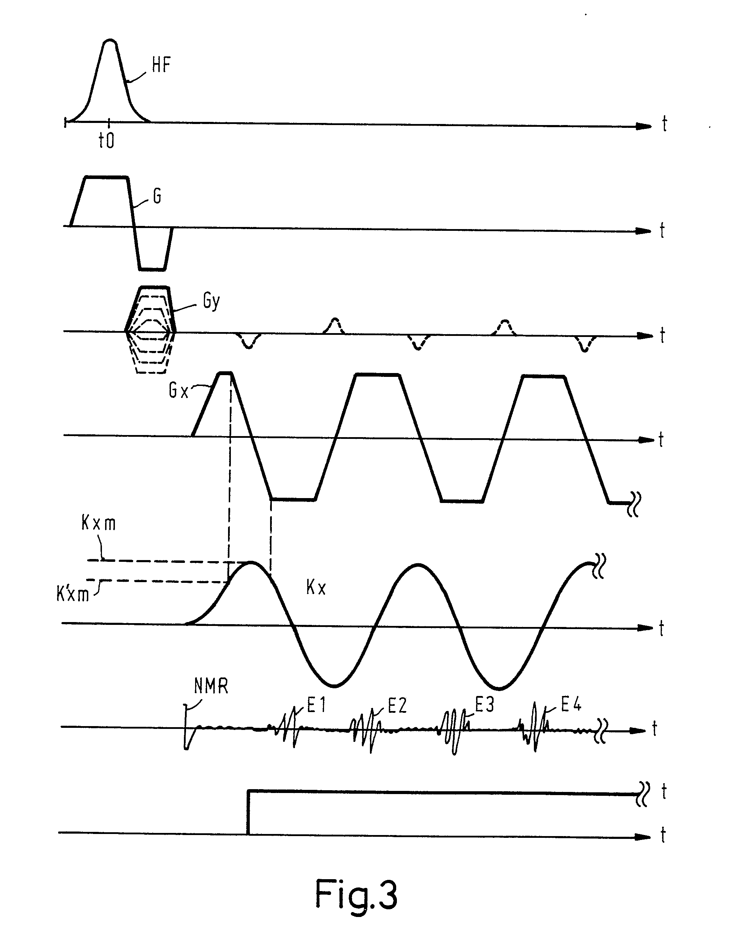

In Fig. 3 ist der zeitliche Verlauf von verschiedenen, mit der Schaltung nach Fig. 2 empfangenen oder erzeugten Signalen für eine enzige Sequenz dargestellt.

Wenn die Hochfrequenspule 11 über den Schalter 12 mit dem Hochfrequenzgenerator 4 gekoppelt ist, wird ein Hochfrequenzimpuls erzeugt, der in der ersten Zeile der Fig. 3 schematisch dargestellt ist. Vorzugsweise handelt es sich hier um einen 90° Impuls, der die Kernmagnetisierung im Untersuchungsbereich um 90° kippt. Die Sequenz kann jedoch auch zwei Hochfrequenzimpulse umfassen, z.B. einen 90° Impuls und anschließend einen 180°-Impuls (Spin-Echo-Technik).

Die zweite Zeile zeigt den zeitlichen Verlauf des von der Spulenanordnung 3 erzeugten Gradientenfeldes. Dieses Gradientenfeld ist während des Hochfrequenzimpulses mit einer ersten Polarität und anschließend mit der entgegengesetzten Polarität wirksam. Der zeitliche Verlauf ist dabei so gewählt, daß das zeitliche Integral über das Gradientenfeld Gz von der Mitte des Hochfrequenzimpulses bis zum Abschalten dieses Gradientenfeldes gerade den Wert Null erreicht. Das Anlegen dieses Gradientenfeldes bewirkt, daß der Hochfrequenzimpuls nur eine bestimmte Schicht anregen kann. Da hierdurch somit eine Schicht selektiert wird, hat sich dafür auch die Bezeichnung "Selektionsgradient" eingebürgert. Der zeitliche Verlauf dieses Gradienten ist ebenso wie der zeitliche Verlauf des Hochfrequenzimpulses für alle Sequenzen bei der Untersuchung einer Schicht gleich.

In der dritten Zeile von Fig. 3 ist der zeitliche Verlauf des von den Spulen 5 erzeugten magnetischen Gradientenfeldes Gy dargestellt. Dieses Feld ist im Anschluß an den Hochfrequenz-Anregungsimpuls (erste Zeile) wirksam und seine Amplitude variiert von Sequenz zu Sequenz; der zeitliche Abstand zwischen zwei aufeinanderfolgenden Sequenzen liegt in der Größenordnung von einer Sekunde. Weil mit Hilfe dieses magnetische Gradientenfeldes die Phasenlage beeinflußt wird, wird dieses Feld auch als "Phasenkodierungsgradient" bezeichnet.

Die vierte Zeile zeigt den zeitlichen Verlauf des von den Spulen 7 erzeugten magnetischen Gradientenfeldes Gx. Während dieses Gradientenfeld anliegt, wird das in der Spule 11 induzierte Signal in dem Hochfrequenzempfänger 6 in digitale Abtastwerte umgesetzt. Dieses Gradientenfeld wird daher auch als Meßgradient bezeichnet. Dieses Gradientenfeld wird eingeschaltet, wenn der Phasenkodierungsgradient Gy abgeschaltet ist. Die Polarität wird dabei periodisch von einem positiven Wert auf einen negativen Wert umgeschaltet, wobei die Zahl der Perioden in einer Sequenz durch das geforderte spektrale Auflösungsvermögen bestimmt ist; enthält die Sequenz beispielsweise zehn Perioden, dann kann die Kernmagnetisierung innerhalb der Bandbreite in zehn Spektralbereichen bestimmt werden.

Die erste positive Halbschwingung des Meßgradienten Gx, die auch schon während des Phasenkodierungsintervalls angelegt werden kann, ist kürzer als die übrigen Halbschwingungen des Meßgradienten, die untereinander gleich sind. Sie ist so ausgelegt, daß das zeitliche Integral über diesen Gradienten bis zur Mitte der ersten negativen Halbschwingung Null ist. Typischerweise betragen die Zeiträume, in denen der Gradient Gx konstant ist, etwa 2 ms und die Umschaltung von der positiven zur negativen Polarität und umgekehrt dauert ebenfalls jeweils 2 ms, so daß sich die Periodendauer der zeitlich trapezförmig verlaufenden Schwingung des Meßgradienten zu 8 ms ergibt. Daraus folgt eine Bandbreite von 125 Hz, innerhalb der die spektrale Verteilung bestimmt werden kann.

Wie sich aus der sechsten Zeile von Fig. 3 ergibt, werden während jeder Halbschwingung des magnetischen Gradientenfeldes Echosignale E1, E2, E3, E4 usw. erzeugt, deren Maximum jeweils in der Mitte der Zeitintervalle liegt, in denen der Gradient jeweils konstant ist. In der siebten Zeile von Fig. 3 ist der Zeitraum angegeben, währenddessen der Verstärker 60 wirksam ist und durch die Analog-Digital-Wandler digitale Abtastwerte erzeugt und in dem Speicher 14 gespeichert werden. Dabei werden auch die Abtastwerte erfaßt, die beim Übergang vom negativen zum postiven Maximalwert des Gradienten auftreten.

In der fünften Zeile ist der zeitliche Verlauf des k Wertes in x-Richtung dargestellt und dort mit kx bezeichnet. Der k Wert ist das Produkt aus dem zeitlichen Integral über das magnetische Gradientenfeld Gx, multipliziert mit dem sogenannten gyromagnetischen Verhältnis, das für Wasserstoffprotonen bei rund 42,5 MHz/T liegt. Der k Wert kann zugleich auch als Raumfrequenz verstanden werden (vgl. Med.Phys. 10 (5), September/Oktober 1983, Seiten 610 bis 621). Der kx-Wert hat ebenfalls einen perodischen Verlauf mit der gleichen Periode wie das magnetische Gradientenfeld, dem er zugeordnet ist, wobei seine Extremwerte bei den Nulldurchgängen des Gradientenfeldes und seine Nulldurchgänge in der Mitte des Zeitintervalls liegen, währenddessen der Gradient konstant und positiv oder negativ ist. Während des letztgenannten Intervalls verläuft der k Wert als Funktion der Zeit linear; während der Umschaltphasen hat der k Wert einen nichtlinearen Verlauf, z.B. einen quadratischen Verlauf, wenn sich der Gradient in den Umschaltphasen zeitlich linear ändert. Wenn man die Abtastwerte, die während der Umschaltphase auftreten, bei der Rekonstruktion der Kernmagnetisierungsverteilung nicht berücksichtigen würde, dann würde der maximal erreichbare k Wert k'xm auf zwei Drittel des maximalen k-Wertes kxm reduziert werden, der sich ergibt, wenn auch die Abtastwerte während der Umschaltphase herangezogen werden. Durch diese Maßnahme wird das räumliche Auflösungsvermögen (d.h. die höchste Raumfrequenz) also um 50 % verbessert.

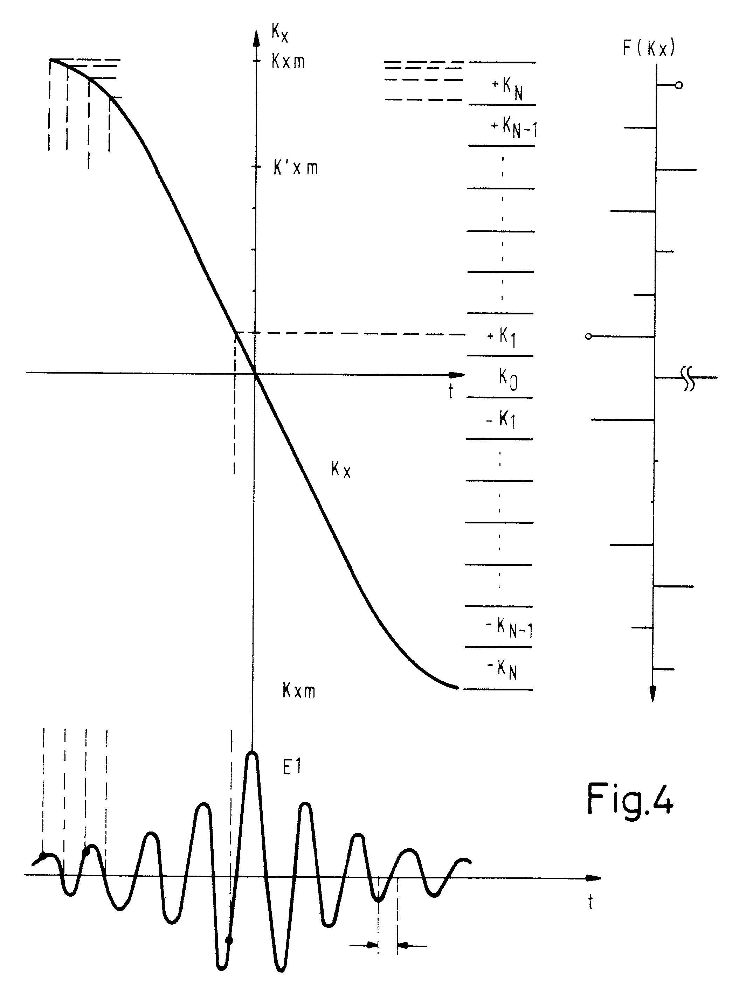

In Fig. 4 ist noch einmal der zeitliche Verlauf kx des k-Wertes in x-Richtung während der ersten negativen Halbschwingung des Gradientenfeldes Gx dargestellt sowie ein zugehöriges Echosignal E1. Dieses Echosignal tritt dann beispielsweise am Ausgang des Tiefpasses 63 auf. Am Ausgang des Tiefpasses 64 tritt ein zweites Echosignal auf, das zu denselben Zeitpunkten abgetastet wird wie E1 und das zusammen mit E1 ein komplexes Echosignal bildet. Jedem Abtastzeitpunkt, in dem das Echosignal E1 (am Ausgang eines der Tiefpässe 63 und 64) in einen digitalen Abtastwert umgesetzt wird, kann ein k-Wert zugeordnet werden, so daß die Folge der Abtastwerte im Zeitbereich in eine Folge von Abtastwerten im kx-Bereich bzw. im Raumfrequenzbereich zugeordnet werden. Wegen der teilweise nichtlinearen Abhängigkeit der kx-Werte von der Zeit, hat die Folge der Abtastwerte im Raumfrequenzbereich einen ungleichmäßigen Abstand, wenn sie im Zeitbereich äquidistant abgetastet wird, und umgekehrt ist einem äquidistanten Abstand der Stützstellen im Raumfrequenzbereich ene nicht äquidistante Abtastung im Zeitbereich zugeordnet. Da das Echosignal jedoch der Fouriertransformierten von dem Raumbereich in den Raumfrequenzbereich entspricht, ist es erforderlich, die Abtastwerte im Raumfrequenzbereich einer Fourier-Transformation zu unterziehen, um die räumliche Verteilung der Kernmagnetisierung im Untersuchungsbereich zu erhalten.

Zu diesem Zweck kann das Echosignal so abgetastet werden (in der Mitte dichter als am Anfang und am Ende), daß die Abtastwerte im kx-Bereich äquidistant sind, weil dann eine Fourier-Transformation ohne weiteres angewandt werden kann. Dies würde allerdings voraussetzen, daß der Taktimpulsgenerator 16, der den Speicher 14 und die Analog-Digital-Wandler 65 und 66 steuert, eine entsprechend veränderbare Taktfrequenz aufweist.

Eine schaltungstechnisch einfachere Möglichkeit besteht darin, die Abtastung in konstanten Zeitintervallen $t_m$ (vgl. Fig. 4) durchzuführen, wobei sich im k-Bereich eine nicht äquidistante Folge der Stützstellen ergibt. In der Zeitschrift "ntz-Archiv" Band 3, 1981, Heft 2, Seite 35 bis 38, ist jedoch ein Transformationsverfahren beschrieben, das auch bei Abtastwerten an nicht äquidistanten Stützstellen benutzt werden kann.

Eine weitere Möglichkeit, die anhand von Fig. 4 erläutert wird, besteht darin, den Raumfrequenzbereich von -kxm bis kxm in 2N+1 gleich große k- bzw. Raumfrequenzintervalle -kN...k0...+kN aufzuteilen; 2N+1 ist dabei die Zahl der Bildelemente, wobei N in der Praxis größer ist als aus Fig. 4 ersichtlich, beispielsweise N = 64. Zweckmäßigerweise wird die Zahl der Abtastungen so hoch gewählt, daß in jedes k-Intervall zumindest ein Abtastwert fällt. Dies ist bei dem angegebenen zeitlichen Verlauf des Gradientenfeldes Gx dann der Falll, wenn im Zeitbereich 8N/3 + 1 äquidistante Abtastungen des Echosignals E1 vorgenommen werden. Wie aus Fig. 4 ersichtlich, ist die Zahl der Abtastwerte, die in das den höheren Raumfrequenzen zugeordnete Raumfrequenzintervall fallen, größer als 1; für das Intervall +kN (-kN) ergeben sich beispielsweise vier Abtastwerte. Wenn mehrere Abtastwerte in ein Raumfrequenzintervall fallen, wird ein resultierender Abtastwert durch Mittelwertbildung ermittelt und dem betreffenden Raumfrequenzintervall zugeordnet. Dadurch wird für diesen Raumfrequenzbereich das Signal/Rauschverhältnis verbessert. Es entsteht dann die in Fig. 4 dargestellte Folge F(kx) von Abtastwerten mit äquidistanten Stützstellen im k-Bereich. Die beschriebene Zuordnung erfolgt mit der Zuordnungseinrichtung 19; ggf. kann sie auch durch den Rechner 17 durchgeführt werden.

Die anhand von Fig. 4 erläuterte Folge bezieht sich lediglich auf die Abtastwerte eines einzigen Echosignals. Wenn man in gleicher Weise die Abtastwerte des Echosignals E3 und alle weiteren Echosignale auswertet, die einem negativen Gradienten zugeordnet sind, ergibt sich ein zweidimensionales Array von Abtastwerten F(kx,t), die eine Funktion der Raumfrequenz n x-Richtung und der Zeit t sind. Die Zeitwerte, die den verschiedenen Echos zugeordnet werden, unterscheiden sich dabei jeweils um eine Periodendauer.

Ist auf diese Weise jedes zweite Echosignal einer Sequenz in eine Folge F(kx,t) von Abtastwerten umgesetzt, wird dies für die anderen Sequenzen wederholt, bei denen -vgl. Fig. 3 -die Höhe des Gradienten Gy von Sequenz zu Sequenz geändert wird. Die Änderung der Amplitude des Phasenkodierungsgradienten Gy entspricht einer Änderung des k-Wertes in y-Richtung -im folgenden ky genannt -, so daß sich letztendlich ein dreidimensionales Array von jeweils äquidistanten Abtastwerten F(kx,ky,t) ergibt, woraus nach Durchführung einer dreidimensionalen diskreten Fourier-Transformation die Kernmagnetisierungsverteilung f(x,y,v) als Funktion des Ortes x,y und der Frequenz v ermittelt werden kann.

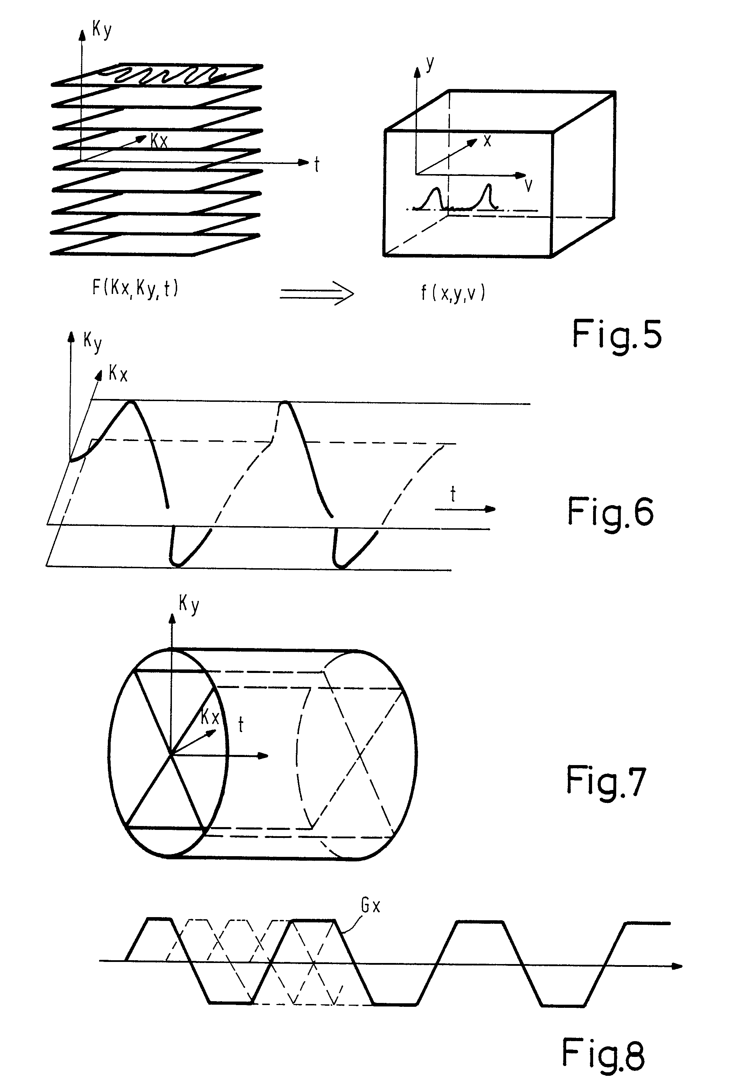

Die Erfassung der Abtastwerte und die damit mögliche Rekonstruktion der räumlichen und spektralen Verteilung der Kernmagnetisierung ist anhand von Fig. 5 erläutert, in der links die Erfassung der Abtastwerte m kx,ky,t Raum dargestellt ist. Danach wird in jeder Sequenz eine kx,t-Ebene periodisch abgetastet und dies in jeder Sequenz für ein anderes ky wiederholt. Die Zahl z der Abtastwerte beträgt dabei $z = (2N + 1)Mp$, wobei $2N + 1$ die Zahl der Abtastwerte ist, die einem Echosignal im kx-Bereich zugeordnet werden, M die Zahl der Sequenzen, die vorzugsweise gleich der Zahl $2N + 1$ ist und p die Anzahl der Perioden des Gradienten Gx in einer Sequenz. Aus diesen z Abtastwerten läßt sich durch die erwähnte dreidimensionale diskrete Fourier-Transformation die Kernmagnetisierung an den Punkten eines Rasters mit $2N + 1$ Punkten in x-Richtung, M Punkten in y-Richtung und p Punkten in v-Richtung bestimmen.

Mit Hilfe der so bestimmten Werte lassen sich Bilder der räumlichen Verteilung der Kernmagnetisierung für eine bestimmte Frequenz erzeugen, die z.B. der Larmorfrequenz der an Fett oder der an Wasser gebundenen Wasserstoffprotonen entspricht, so daß getrennte Fett-und Wasserbilder erzielt werden können. Es ist aber auch möglich, für einen bestimmten Punkt die spektrale Verteilung der Kernmagnetisierung anzugeben und daraus die Zusammensetzung des Gewebes in diesem Punkt.

Wenn das stationäre Magnetfeld im Untersuchungsbereich nicht homogen ist, liegen die Maxima der Kernmagnetisierung nicht an der gleichen Stelle des Spektralbereiches. Dies könnte bei Aufnahmeverfahren mit geringer spektraler Auflösung, z.B. dem Dixon-Verfahren, das nur zwei Spektralpunkte auflöst, zu Fehlern bei der Trennung von Fett-und Wasserbildern führen. Bei dem erfindungsgemäßen Verfahren kann diese ortsabhängige Verschiebung des Spektrums bei der Rekonstruktion korrigiert werden, weil die Inhomogenität des magnetischen Gradientenfeldes der Spule gleich bleibt und meßtechnisch erfaßt werden kann.

Bei dem erfindungsgemäßen Verfahren sind zur Bestimmung der spektralen und räumlichen Verteilung der Kernmagnetisierung M Sequenzen erforderlich, wobei M beispielsweise 128 beträgt. Wenn der zeitliche Abstand zwischen dem Beginn zweier aufeinanderfolgender Sequenzen beispielsweise eine Sekunde beträgt, bedeutet dies, daß die erforderliche Messung in nur rund zwei Minuten durchgeführt werden kann.

Wie vorstehend erwähnt, erfordert die Rekonstruktion der Kernmagnetisierungsverteilung lediglich die Umsetzung jedes zweiten Echosignals, so daß auf die Abtastung der dazwischen liegenden Echosignale grundsätzlich verzichtet werden kann. Wenn man diese jedoch ebenfalls abtastet und getrennt einer Fourier-Transformation unterzieht, ergibt sich eine Kernmagnetisierungsverteilung f'(x,y,v), die mit der Verteilung f(x,y,v) übereinstimmen würde, wenn nicht die Echosignale durch Rauschen gestört werden. Das Signal-Rauschverhältnis kann daher verbessert werden, wenn die Werte f(x,y,v) undf'(x,y,v) zueinander addiert werden.

Es ist jedoch auch möglich, die Tatsache, daß für die Rekonstruktion der Kernmagnetisierung in einer kx-t-Ebene nur jedes zweite Echosignal benötigt wird, dazu auszunutzen, um mit einer Sequenz zwei solcher Ebenen zu erfassen. Wie in Fig. 3 in Zeile drei gestrichelt angedeutet, wird zu diesem Zweck während der Umschaltphasen des Gradientenfeldes Gx das Gradientenfeld Gy abwechselnd mit positiver und negativer Polarität so eingeschaltet, daß das zeitliche Integral über das magnetische Gradientenfeld während einer solchen Umschaltphase +ky/M oder -ky/M beträgt, wobei ky der größte k-Wert aller Sequenzen in y-Richtung ist und M die Zahl der Punkte in y-Richtung angibt, für die die Kernmagnetisierung bestimmt werden soll. Die Wirkung dieser Maßnahme ist in Fig. 6 erläutert, die zwei benachbarte kx-t-Ebenen zeigt. Während der negativen Halbschwingung des Gradienten Gx, wobei der kx-Wert abnimmt, ändert sich das Gradientenfeld Gy zunächst nicht, so daß Abtastwerte in der oberen kx-t-Ebene erfaßt werden. Am Ende dieser Halbschwingung wird der ky-Wert um den Betrag ky/M verringert, und in der darauffolgenden positiven Halbschwingung des Gradientenfeldes Gx (ansteigender Verlauf der kx-Werte) werden die Abtastwerte in der benachbarten darunter befindlichen Ebene erfaßt. Am Ende dieser Halbschwingung erfolgt eine Abtastung wiederum in der darüber befindlichen Ebene usw.

Auch wenn das in den Umschaltphasen angelegte Gradientenfeld Gy relativ klein ist, kann der Übergang von einer Ebene zur anderen nicht beliebig schnell erfolgen. Infolgedessen wird während der Umschaltphasen auch ein Teil des zwischen den beiden Ebenen liegenden Gebietes durchlaufen, wobei ein Teil der dabei erfaßten Abtastwerte der oberen Ebene und der andere Teil der unteren Ebene zugeordnet wird. Dies wirkt sich jedoch kaum auf die Bildqualität aus, weil die Kernmagnetisierungsverteilung in benachbarten Ebenen zumindest annähernd gleich ist.

Vorstehend wurde die Erfindung in Verbindung mit einem mehrdimensionalen Fourier-Transformationsverfahren erläutert, doch ist die Erfindung darauf nicht beschränkt. Sie kann auch in Verbindung mit einem Projektionsverfahren benutzt werden, wobei von Sequenz zu Sequenz nicht der Betrag der Gradientenfelder variiert wird, sondern ihre Richtung. In diesem Fall müßten sowohl in x-als auch in y-Richtung zueinander synchrone periodische Gradientenfelder angelegt werden, deren Größe von Sequenz zu Sequenz stufenweise gegensinnig geändert wird, so daß die Summe der Quadrate über die Maxima der Gradienten Gx, Gy konstant bleibt. Die Abtastwerte würden bei einem derartigen Verfahren im kx-ky-t-Abtastraum nicht auf parallelen Ebenen erfaßt, sondern auf Ebenen, die sich in der Geraden kx=ky=0 schneiden (vgl. Fg. 7). Auch hierbei könnte die Meßzeit halbiert werden, wenn mit den beiden Halbschwingungen winkelmäßig benachbarte Ebenen abgetastet würden. Zu diesem Zweck müßten die Gradienten innerhalb der Sequenz von Halbschwingung zu Halbschwingung geringfügig geändert werden.

Gemäß Fig. 3 umfaßt jede Sequenz nur einen einzigen Hochfrequenzimpuls, jedoch können auch Sequenzen mit mehreren Hochfrequenzimpulsen, z.B. mit einem 90°-Impuls und einem darauffolgenden 180°-Impuls (Spin-Echo-Verfahren) oder Sequenzen mit drei aufeinanderfolgenden Hochfrequenzimpulsen (stimuliertes Echo-Verfahren) verwendet werden.

Wie bereits erwähnt, entspricht die spektroskopisch auflösbare Bandbreite bei dem erfindungsgemäßen Verfahren dem Kehrwert einer Periodendauer (in dem angegebenen Beispiel also 125 Hz). Wenn in dem Untersuchungsbereich Stoffe sind, die einen nennenswerten Beitrag zum Echosignal liefern und deren Frequenzabstand größer ist als die Bandbreite, dann werden die Spektren dieser Stoffe ineinander gefaltet (backfolding). Eine spektrale Trennung ist in solchen Fällen nicht mehr möglich. Der Frequenzabstand zwischen zwei Stoffen ist der Stärke des stationären homogenen Magnetfeldes proportional. Bei einem stationären Magnetfeld von 0,5 T beträgt die Differenz der Larmorfrequenzen von an Wasser gebundenen Wasserstoffprotonen einerseits und von an Fett gebundenen Wasserstoffprotonen andererseits 70 Hz. Bei einem stationären Magnetfeld von 2T beträgt dieser Frequenzabstand jedoch - schon rund 280 Hz, so daß eine spektroskopische Trennung von Fett und Wasser nicht mehr möglich ist.

Um auch in diesem Fall Fett und Wasser spektroskopisch trennen zu können, wird die Bandbreite mit einem an sich bekannten Verfahren (vgl. "J.Magn.Reson." Seiten 167 bis 171 (1985)) vervielfacht. Dabei wird jede Sequenz n mal wiederholt (wobei n eine ganze Zahl größer 1 ist), wobei lediglich der Abstand zwischen dem Hochfrequenzimpuls und dem periodischen Gradientenfeld Gx von Sequenz zu Sequenz um den Betrag T/n geändert wird, wie in Fig. 8 gestrichelt angedeutet. Schaltet man demgemäß ein Gradientenfeld Gx mit einer Periodendauer von 8 ms in vier Sequenzen ein, wobei der Abstand zum Hochfrequenzanregungsimpuls jeweils um 2 ms variiert wird, dann ergibt sich eine Vervierfachung der Bandbreite (auf 500 Hz), eine vierfach größere Zahl von Spektralwerten -jedoch auch eine viermal so große Meßzeit.

## Ansprüche

1. Verfahren zur Bestimmung der räumlichen und der spektralen Verteilung der Kernmagnetisierung in einem Untersuchungsbereich, bei dem in Anwesenheit eines homogenen stationären Magnetfeldes eine Anzahl von Sequenzen auf den Untersuchungsbereich einwirkt, wobei jede Sequenz mindestens einen magnetischen Hochfrequenzimpuls zur Anregung kernmagnetischer Resonanz und daran anschließend mehrere Perioden eines magnetischen Gradientenfeldes mit periodisch seine Polarität änderndem Gradienten umfaßt, wonach die dabei im Untersuchungsbereich erzeugten Echosgnale n digitale Abtastwerte umgesetzt und diese einer diskreten Fourier-Transformation unterzogen werden, dadurch gekennzeichnet, daß der zeitliche Verlauf des magnetschen Gradientenfeldes (Gx) von der Rechteckform abweicht, daß auch die Abtastwerte erfaßt werden, die auftreten, wenn das Gradientenfeld sich ändert und daß diese und die übrigen Abtastwerte dem Raumfrequenzbereich zugeordnet und aus diesem durch die Fourier-Transformation in den Raumbereich transformiert werden.

2. Verfahren nach Anspruch 1,
dadurch gekennzeichnet, daß die Abtastwerte vor der Transformation einem Raumfrequenzraster mit gleich großen Intervallen zugeordnet werden.

3. Verfahren nach Anspruch 1 oder 2,
dadurch gekennzeichnet, daß in jeder Sequenz nach dem Hochfrequenzimpuls ein magnetisches Gradientenfeld (Gy) angelegt wird, dessen Gradient in einer Richtung senkrecht zur Richtung des danach eingeschalteten periodischen Gradientenfeldes (Gx) verläuft und dessen Amplitude und/oder Dauer von Sequenz zu Sequenz geändert wird.

4. Verfahren nach einem der Ansprüche 1 bis 3,
dadurch gekennzeichnet, daß es n gleichartige Sequenzen umfaßt, die sich lediglich dadurch unterscheiden, daß der zeitliche Abstand zwischen dem Hochfrequenzimpuls und dem Einschalten des periodischen Gradientenfeldes jeweils um den Zeitraum T/n geändert wird, wobei n eine ganze Zahl größer als 1 ist und T die Periodendauer des magnetischen Gradientenfeldes.

5. Verfahren zur Bestimmung der räumlichen und der spektralen Verteilung der Kernmagnetisierung in einem Untersuchungsbereich, bei dem in Anwesenheit eines homogenen stationären Magnetfeldes eine Anzahl von Sequenzen auf den Untersuchungsbereich einwirkt, wobei jede Sequenz mindestens einen Hochfrequenzimpuls zur Anregung kernmagnetischer Resonanz und daran anschließend ein erstes zwischen einem positiven Gradienten und einem negativen Gradienten umgeschaltetes Gradientenfeld umfaßt, wonach die dabei im Untersuchungsbereich erzeugten Echosgnale in digitale Abtastwerte umgesetzt und diese einer diskreten Fourier-Transformation unterzogen werden, insbesondere nach Anspruch 1, dadurch gekennzeichnet, daß auch ein zweites magnetisches Gradientenfeld, dessen Gradienten senkrecht zum Gradienten des ersten Gradientenfeldes verläuft, synchron mit dem ersten Gradientenfeld umgeschaltet wird, wobei die Änderung des zeitlichen Integrals über den Gradienten des zweiten Gradientenfeldes klein ist im Vergleich zu dem zeitlichen Integral über den resultierenden Gradienten beider Gradientenfelder, und daß die bei positivem Gradienten des ersten magnetischen Gradientenfeldes einerseits und bei negativem Gradienten andererseits auftretenden Echosignale in digitale Abtastwerte umgesetzt und getrennt einer Fourier-Transformation unterzogen werden.

6. Verfahren nach Anspruch 5,
dadurch gekennzeichnet, daß während der Umschaltphase des ersten magnetischen Gradientenfeldes das zweite Gradientenfeld mit von Umschaltphase zu Umschaltphase wechselnder Polarität engeschaltet wird, wobei sein Gradient klein ist im Vergleich zum Gradienten des ersten Gradientenfeldes.

7. Anordnung zur Durchführung des Verfahrens nach Anspruch 1 mit einem Magneten zur Erzeugung eines homogenen stationären Magnetfeldes, einer Hochfrequenzspule zur Erzeugung von Hochfrequenzanregungsimpulsen, Gradientenspulen zur Erzeugung von magnetischen Gradientenfeldern mit in unterschiedlichen Richtungen verlaufenden Gradienten, einer Steuereinrichtung zur Steuerung des zeitlichen Verlaufs der mit den Gradientenspulen erzeugten Felder, einer Digital-Wandler-Aordnung zur Erzeugug digitaler Abtastwerte aus den Echosignalen, einem Speicher zur Aufnahme der Abtastwerte und einem Rechner zur Durchführung einer Fourier-Transformation mit den Abtastwerten, dadurch gekennzeichnet, daß die Steuereinrichtung (15) so ausgelegt ist, daß wenigstens eine der Gradientenspulen (7) ein periodisches Magnetfeld - (Gx) mit einem von der Rechteckform abweichenden zeitlichen Verlauf erzeugt, daß während der Zeiträume mit nicht konstantem Gradienten von der Digital-Wandler-Anordnung (65, 66) aus den Echosignalen (E1, E3...) digitale Abtastwerte erzeugt und in dem Speicher gespeichert werden, und daß Mittel (19) vorgesehen sind, die die Folge der Abtastwerte in eine in Raumfrequenzbereich äquidistante Folge von Werten (F(kx,...)) umsetzen, die dem Rechner zur Fourier-Transformation vom Raumfrequenzbereich in den Raumbereich zugeführt werden.

8. Anordnung zur Durchführung des Verfahrens nach Anspruch 5 mit einem Magneten zur Erzeugung eines homogenen stationären Magnetfeldes, einer Hochfrequenzspule zur Erzeugung von Hochfrequenzanregungsimpulsen, Gradientenspulen zur Erzeugung von magnetischen Gradientenfeldern mit in unterschiedlichen Richtungen verlaufenden Gradienten, einer Steuereinrichtung zur Steuerung des zeitlichen Verlaufs der mit den Gradientenspulen erzeugten Felder, einer Digital-Wandler-Aordnung zur Erzeugug digitaler Abtastwerte aus den Echosignalen, einem Speicher zur Aufnahme der Abtastwerte und einem Rechner zur Durchführung einer Fourier-Transformation mit den Abtastwerten, dadurch gekennzeichnet, daß die Steuereinrichtung (15) so ausgebildet ist, daß mit zwei Gradientenspulen (5, 7) synchron zueinander periodische Gradientenfelder erzeugt werden und daß der Rechner zur Durchführung der Fourier-Transformation so bemessen ist, daß die digitalen Abtastwerte jedes zweiten Echosignals einerseits und die digitalen Abtastwerte der übrigen Echosignale andererseits getrennt verarbeitet werden.

9. Anordnung nach einem der Ansprüche 7 oder 8,
dadurch gekennzeichnet, daß die Steuereinrichtung so ausgebildet ist, daß der zeitliche Abstand zwischen dem Hochfrequenzanregungsimpuls und der Einschaltdauer des periodischen Gradientenfeldes um den Wert T/n veränderbar ist, wobei n eine ganze Zahl und T die Periodendauer des Gradientenfeldes ist.

Fig.1

Fig. 2

Fig.3

Fig.4

$F(Kx, Ky, t)$ $\Longrightarrow$ $f(x, y, v)$

Fig.5

Fig.6

Fig.7

Fig.8